# EUROPEAN PATENT APPLICATION

(11) **EP 4 790 903 A1**
(43) Date of publication of application: **12.08.2026**
(21) Application number: 26156148.4
(22) Date of filing: 03.02.2026
(51) Int. Cl.: H03M 1/10, H03M 1/14, H03M 1/16

(54) **CLOCK PHASE CONTROL TO ADJUST QUANTIZER-DAC DELAY FOR CONTINUOUS-TIME PIPELINED ADCS**

(30) Priority: 05.02.2025 US 202519046342
(71) Applicant: Analog Devices International Unlimited Company, Limerick (IE)
(72) Inventor: LULEC, Sevil Zeynep, Co. Limerick (IE); SHIBATA, Hajime, Co. Limerick (IE); CHEN, Wei-Hung, Wilmington, 01887 (US); KENNEY, John, Wilmington, 01887 (US)
(74) Representative: Wallin, Nicholas James

(57) **Abstract**

Techniques are described to control the quantizer clock edge to adjust a delay of the feedforward path, which includes the quantizer and the digital-to-analog converter (DAC), to sustain matching over varying clock frequencies as well as over process, voltage, and temperature (PVT). A digitally controlled phase/time delay generating block may be used to control the quantizer clock edge, in an open loop or within a feedback loop, to provide the required time delay or advancement. Calibrations may be performed in the foreground and/or background. Using various techniques, the delay element design may focus on accurate wideband matching without focusing on tunability over varying clock frequencies.

## Description

### FIELD OF THE DISCLOSURE

This document pertains generally, but not by way of limitation, to analog-to-digital converters (ADCs).

### BACKGROUND

Real-world analog signals such as temperature, pressure, sound, or light are routinely converted to a digital representation that may be easily processed in modern digital signal processing systems. The circuits that perform this conversion of an analog input signal to a digital output signal are referred to as analog-to-digital converters (ADCs). ADCs may translate analog electrical signals representing real-world phenomena such as temperature, pressure, sound, or light to digital signals for data processing purposes.

ADCs may be found in many places such as broadband communication systems, audio systems, receiver systems, etc., and are used in a broad range of applications including communications, energy, healthcare, instrumentation and measurement, motor and power control, industrial automation and aerospace/defense. For example, in precision measurement systems, electronics may be provided with one or more sensors to make measurements, and these sensors may generate an analog signal. The analog signal is then provided to an ADC as an input to generate a digital output signal for further processing. In another example, an antenna may generate an analog signal based on the electromagnetic waves carrying information/signals in the air. The analog signal generated by the antenna is then provided as an input to an ADC to generate a digital output signal for further processing.

Designing an ADC is a non-trivial task because each application may have different needs in speed, performance, power, cost, and size. As the applications needing ADCs grow, the need for accurate and reliable conversion performance also grows.

### SUMMARY OF THE DISCLOSURE

This disclosure describes techniques to control the quantizer clock edge to adjust a delay of the feedforward path, which includes the quantizer and the digital-to-analog converter (DAC), to sustain matching over varying clock frequencies as well as over process, voltage, and temperature (PVT). A digitally controlled phase/time delay generating block may be used to control the quantizer clock edge, in an open loop or within a feedback loop, to provide the required time delay or advancement. Calibrations may be performed in the foreground and/or background. Using various techniques of this disclosure, the delay element design may focus on accurate wideband matching without focusing on tunability over varying clock frequencies.

In some aspects, this disclosure is directed to a residue generation arrangement for use in a continuous-time stage of an analog-to-digital converter (ADC), the residue generation arrangement comprising: a forward path including a continuous-time filter, the forward path coupled with an analog input and configured for receiving an analog input signal applied to the analog input and generating a delayed analog input signal; a feedforward path coupled in parallel with the forward path, the feedforward path including: a quantizer for digitizing the analog input signal to generate a digital signal; and a digital-to-analog converter (DAC) coupled with an output of the quantizer and configured for receiving the digital signal from the quantizer and generating a feedforward path analog output signal based on the digital signal generated by the quantizer; a summation node configured for generating a residue signal based on the delayed analog input signal and the feedforward path analog output signal; and a timing adjustment circuit configured for receiving a clock signal and an adjustment signal and, in response, generating a delayed or advanced clock signal that is applied to a clock input of one or both of the quantizer and the DAC to adjust a clock phase or clock delay of the feedforward path.

In some aspects, this disclosure is directed to a residue generation arrangement for use in a continuous-time analog-to-digital converter (ADC), the residue generation arrangement comprising: a first continuous-time stage including: a forward path including a continuous-time filter, the forward path coupled with an analog input and configured for receiving an analog input signal applied to the analog input and generating a delayed analog input signal; a feedforward path coupled in parallel with the forward path, the feedforward path including: a first quantizer for digitizing the analog input signal to generate a digital signal; and a digital-to-analog converter (DAC) coupled with an output of the first quantizer and configured for receiving the digital signal from the first quantizer and generating a feedforward path analog output signal based on the digital signal generated by the first quantizer; a summation node configured for generating a residue signal based on the delayed analog input signal and the feedforward path analog output signal; a timing adjustment circuit configured for receiving a clock signal and an adjustment signal and, in response, generating a delayed or advanced clock signal that is applied to a clock input of one or both of the first quantizer and the DAC to adjust a clock phase or clock delay of the feedforward path; and a calibration unit configured for controlling a relationship between the delayed clock signal and the clock signal applied to an input of the digital-to-analog converter (DAC).

In some aspects, this disclosure is directed to a method of using an analog-to-digital converter (ADC), the method comprising: receiving an analog input signal applied to an analog input and generating a delayed analog input signal; digitizing, via a feedforward path, the analog input signal to generate a digital signal; receiving the digital signal and generating a feedforward path analog output signal based on the digital signal; generating a residue signal based on the delayed analog input signal and the feedforward path analog output signal; and receiving a clock signal and an adjustment signal and, in response, generating a delayed or advanced clock signal that is applied to a clock input of one or both of a quantizer and a digital-to-analog converter to adjust a clock phase or clock delay of the feedforward path.

### BRIEF DESCRIPTION OF THE DRAWINGS

In the drawings, which are not necessarily drawn to scale, like numerals may describe similar components in different views. The drawings illustrate generally, by way of example, but not by way of limitation, various embodiments discussed in the present document.
FIG. 1 is a block diagram of an example of a continuous-time pipelined analog-to-digital converter that may implement various techniques of this disclosure.
FIG. 2 is a block diagram of a portion of the analog-to-digital converter of FIG. 1 in more detail.
FIG. 3 is a block diagram of an example of a residue generation arrangement for use in a continuous-time stage of an analog-to-digital converter (ADC), in accordance with various techniques of this disclosure.
FIG. 4 is a block diagram of an example of a timing adjustment circuit that may implement various techniques of this disclosure.
FIG. 5 is a block diagram of an example of a calibration unit for controlling a relationship between the delayed or advanced clock signal and the clock signal in accordance with this disclosure.
FIG. 6 is a block diagram of another example of a residue generation arrangement with discrete-time signal representation and the quantization noise incurred at the output of the quantizers.
FIG. 7 is an example of an implementation of a least means square (LMS) by the calibration unit of FIG. 6.
FIG. 8 is a conceptual model of an equivalent-circuit example of a residue generation arrangement.
FIG. 9 is another example of an implementation of a least means square (LMS) by the calibration unit of FIG. 6.
FIG. 10 is a flow diagram of an example of a method of using a continuous-time analog-to-digital converter (ADC) using various techniques of this disclosure.

### DETAILED DESCRIPTION

Continuous-time pipelined (CTP) analog-to-digital converters (ADC) are an emerging architecture that has been used for the last decade in various applications, including telecommunication, mainly due to their superior system-level benefits, including inherent anti-aliasing and easy-to-drive resistive input impedance, and wide-bandwidth operation. Most CTP ADCs rely on a delay element to provide matching over the desired bandwidth and some sort of component tuning, or tapping, to cover varying clock frequencies. The present inventors have recognized that this poses a significant challenge to the delay element design, which already needs to handle accurate wideband matching. The present inventors have recognized a need to match the delay in a feedforward path with a delay in the forward path of a CTP ADC.

This disclosure describes techniques to control the quantizer clock edge to adjust a delay of the feedforward path, which includes the quantizer and the digital-to-analog converter (DAC), to sustain matching over varying clock frequencies as well as over process, voltage, and temperature (PVT). A digitally controlled phase/time delay generating block may be used to control the quantizer clock edge, in an open loop or within a feedback loop, to provide the required time delay or advancement. Calibrations may be performed in the foreground and/or background. Using various techniques of this disclosure, the delay element design may focus on accurate wideband matching without focusing on tunability over varying clock frequencies.

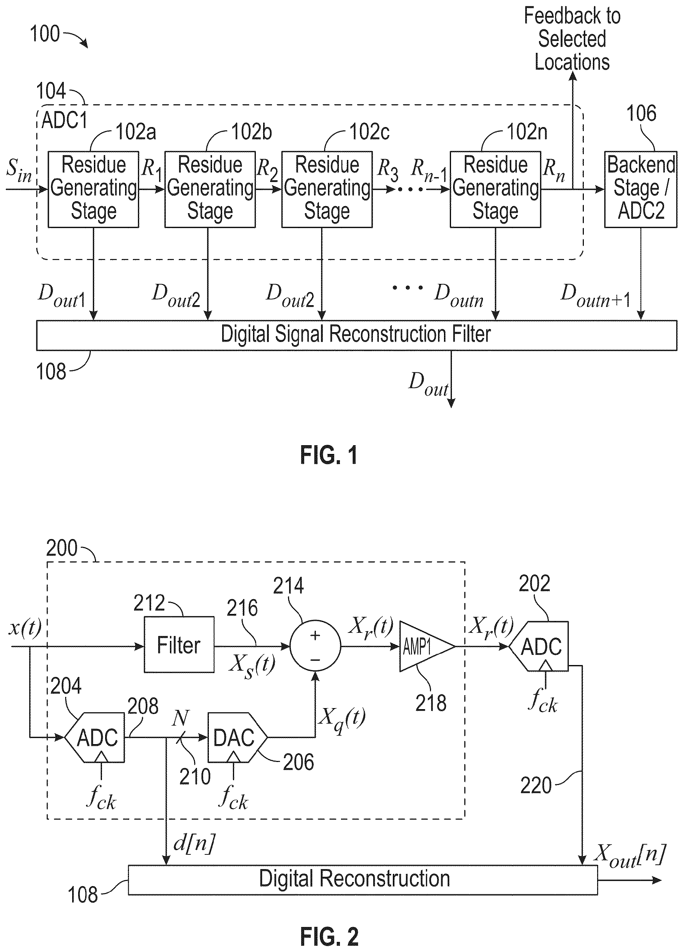

FIG. 1 is a block diagram of an example of a continuous-time pipelined analog-to-digital converter 100 that may implement various techniques of this disclosure. The continuous-time pipelined analog-to-digital converter 100 includes two or more stages connected in series (or pipelined) in a cascading configuration where the output of one stage feeds into the input of the next stage. Specifically, the pipelined analog-to-digital converter 100 has a N (number of) residue-generating stages, shown as residue-generating stage 102a, residue-generating stage 102b, ... , and residue-generating stage 102n. N may be greater than or equal to 1 and may vary depending on the design of the analog-to-digital converter 100.

Collectively, the N residue-generating stages make up a first ADC 104 (ADC1). In some examples, the analog-to-digital converter 100 further includes a second ADC 106 (ADC2). The second ADC 106 digitizes an amplified residue signal from the N^{th} residue-generating stage 102n. The second ADC 106 may be referred to as a backend stage or a backend ADC.

Each stage (either a residue-generating stage or the backend stage) may receive a respective analog input signal and generate a respective digital output signal. If a stage is a residue-generating stage, then the stage also generates an amplified residue signal (an analog output signal). The digital output signal of a stage is generated through quantization and digitization, or analog-to-digital conversion of the analog input signal of a stage. A residue-generating stage may form the amplified residue signal through summation/subtraction of the analog input signal and a reconstructed analog input signal of the stage. The residue-generating stage may form a reconstructed analog input signal of the stage by converting the digital output signal back into an analog signal.

Referring back to FIG. 1, a first residue-generating stage 102a receives an analog input signal, S_{IN}, at an analog input terminal of the analog-to-digital converter 100 and generates a digital output signal D_{OUT1} and an amplified residue signal R₁. The second residue-generating stage 102b receives the amplified residue signal R₁ from the first residue-generating stage 102a as its analog input signal, and generates a digital output signal D_{OUT2} and an amplified residue signal R₂. The third residue-generating stage 102c receives the amplified residue signal R₂ from the second residue-generating stage 102b as its analog input signal, and generates a digital output signal D_{OUT3} and an amplified residue signal R₃, and so on. The last, or N^{th}, residue-generating stage 102n receives an amplified residue signal R_{N-1} from the N-1^{th} residue generating stage as its analog input signal, and generates a digital output signal D_{OUTN} and an amplified residue signal R_{N}. If present, the second ADC 106, e.g., a backend stage, receives an amplified residue signal R_{N} from the N^{th} residue-generating stage 102n as its analog input signal, and generates a digital output signal D_{OUTN+1} (no amplified residue signal is generated).

The digital output signals, D_{OUT1}, D_{OUT2}, D_{OUT3}, ... , D_{OUTN}, and D_{OUTN+1} from the residue-generating stages, such as the residue-generating stages 102a-102n are filtered and combined in the digital domain by a digital signal reconstruction filter 108 to form a final digital output signal D_{OUT} of the analog-to-digital converter 100. The final digital output signal D_{OUT} is thus a digital version of the analog input signal S_{IN}.

The stages may have the same number of bits for digital resolution, or the stages may have different numbers of bits for digital resolution. Resolution of the stages may depend on the design.

FIG. 2 is a block diagram of a portion of the analog-to-digital converter of FIG. 1 in more detail. In particular, FIG. 2 depicts a residue-generating stage 200 in more detail. The residue-generating stage 200 is an example of one of the residue-generating stages, e.g., residue-generating stage 102a, of FIG. 1 and the second ADC 202 is an example of the second ADC 106 of FIG. 1.

As shown in FIG. 2, a continuous time (CT) analog input signal, x(t) (shown as S_{IN} in FIG. 1), is applied to the analog input terminal of the residue-generating stage 102a sent to two different parallel paths: a feedforward path and a forward path. The feedforward path includes a cascade of a quantizer 204 for digitizing the analog input signal to generate a digital signal and a feedforward digital-to-analog converter 206 coupled with an output 208 of the quantizer 204 and configured for receiving the digital signal 210 from the quantizer 204 and generating a feedforward path analog output signal Xq(t) based on the digital signal 210 generated by the quantizer 204.

The forward path is coupled in parallel with the feedforward path and the forward path includes a circuit configured to apply an analog delay to the input signal x(t). Thus, the CT analog input x(t) is applied to the continuous-time filter 212 (a delay element) in the forward path and to a cascade of the N-bit ADC implementing the quantizer 204 and an N-bit DAC implementing the feedforward digital-to-analog converter 206, which may be clocked at a sampling rate f_{ck} in the feedforward path.

A summation node 214 (e.g., a subtractor) may then generate a residue signal, xᵣ(t), based on a delayed analog input signal 216 xₛ(t), which is the output of the forward path, and an output, x_{q}(t), of the digital-to-analog converter 206 (which is the output of the feedforward path). For example, the summation node 214 generates the residue signal xᵣ(t) by subtracting the feedforward path output x_{q}(t) from the forward path output, namely the delayed analog input signal 216 xₛ(t), or the other way around. The residue signal xᵣ(t) may then be processed, e.g., filtered and amplified by an amplifier 218 ("AMP₁"), where the amplifier 218 provides interstage gain when multiple stages are used. In some examples, the residue signal xᵣ(t) may be provided to subsequent pipeline stages in an ADC, such as shown in FIG. 1. Eventually, a signal based on the processed residue signal xᵣ(t) may be provided to a backend ADC 202, to be digitized by the backend ADC 202 to generate a digital residue signal 220. The analog-to-digital converter 100 may further include a digital signal reconstruction filter 108, configured to generate an ADC output xₒᵤₜ[n] based on the digital residue signal 220 (digital residue signal 220 is shown as D_{OUTN+1} in FIG. 1), a digital signal d[n] output by the quantizer 204, and any digital signal generated by the quantizers in the intermediate pipeline stages in the ADC (such as shown in FIG. 1).

The quantizer 204, the digital-to-analog converter 206, the continuous-time filter 212, the summation node 214, and the amplifier 218 may be considered to be a first stage, or a residue generation arrangement, of the analog-to-digital converter 100 of FIG. 1.

The present inventors have recognized that continuous-time ADCs, including continuous-time pipeline (CTP) ADCs, may achieve better signal-to-noise performance for a given back-end stage if xₛ(t) and x_{q}(t) matching is achieved. With better matching, xᵣ(t) will be limited by the sub-ADC quantization noise, which enables higher inter-stage amplification and, thus higher noise suppression of the following pipelined stages. The forward path and the feedforward path matching should be sustained for the desired bandwidth as well as for various clock frequencies (f_{CK}) to implement a general-purpose ADC. As shown and described in more detail below, a digitally controller phase/time delay generating block ("TGEN") may be used to control the quantizer clock edge, in an open loop or within a feedback loop, to provide the desired time delay. For brevity, the disclosure describes generating a delayed clock signal but the techniques are also applicable for generating an advanced clock signal, that is applied to a clock input of one or both of the quantizer and the DAC to adjust a clock phase or clock delay of the feedforward path.

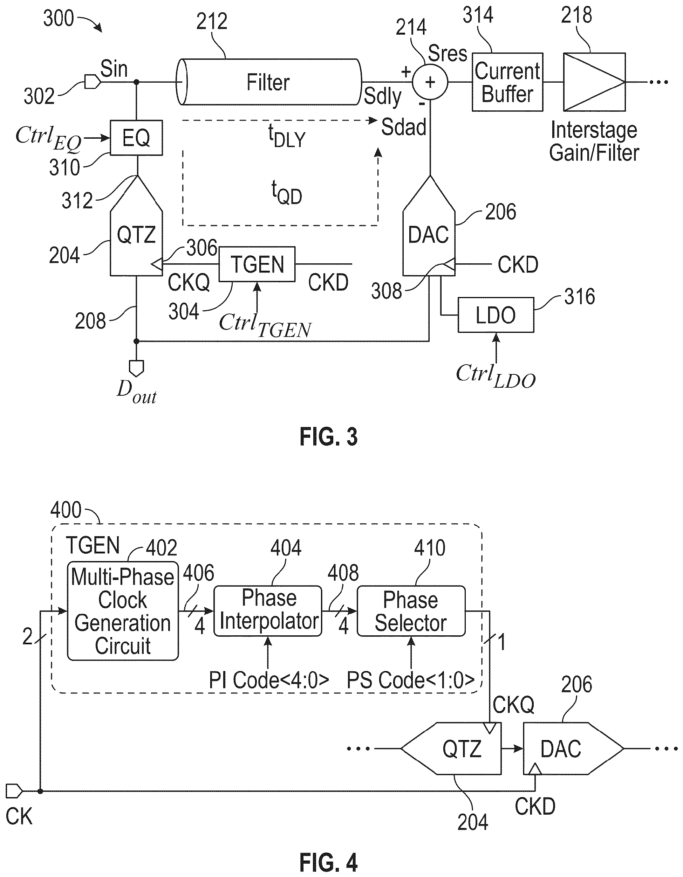

FIG. 3 is a block diagram of an example of a residue generation arrangement for use in a continuous-time stage of an analog-to-digital converter (ADC), in accordance with various techniques of this disclosure. For example, the residue generation arrangement 300 may be used with the analog-to-digital converter 100 of FIG. 1.

The residue generation arrangement 300 includes a forward path including a continuous-time filter 212. In some examples, the continuous-time filter 212 has a fixed delay. In other examples, the continuous-time filter 212 has a variable delay. The continuous-time filter 212 may be implemented using one or more of an LC delay, an RC delay, or a transmission line, or a combination of these.

The forward path is coupled with an analog input terminal 302 and configured for receiving an analog input signal S_{IN} applied to the analog input terminal 302 and generating a delayed analog input signal S_{DLY}.

The residue generation arrangement 300 includes a feedforward path coupled in parallel with the forward path. The feedforward path includes a quantizer 204 for digitizing the analog input signal S_{IN} to generate a digital signal D_{OUT}. The feedforward path also includes a digital-to-analog converter 206 coupled with an output 208 of the quantizer 204 and configured for receiving the digital signal D_{OUT} from the quantizer 204 and generating a feedforward path analog output signal S_{DAC} based on the digital signal D_{OUT} generated by the quantizer 204. The residue generation arrangement 300 includes a summation node 214 configured for generating a residue signal S_{RES} based on the delayed analog input signal S_{DLY} and the feedforward path analog output signal S_{DAC}.

In accordance with this disclosure, the residue generation arrangement 300 includes a timing adjustment circuit 304 (TGEN) configured for receiving a clock signal and an adjustment signal CTRL_{TGEN}, such as a digital code or a feedback signal, and, in response, generating a delayed or advanced clock signal that is applied to a clock input 306 of the quantizer 204 (clock signal CKQ) and/or a clock input 308 of the digital-to-analog converter 206 (clock signal CKD) to adjust a clock phase or clock delay of the feedforward path. In this manner, the timing adjustment circuit 304 adjusts a delay t_{QD} of the feedforward path to more closely match the delay t_{DLY} of the forward path.

In some examples, the tuning range of the timing adjustment circuit 304 covers an octave of clock frequencies. In some examples, the timing adjustment circuit 304 controls the clock to adjust the feedforward path phase and/or timing. In other examples, the timing adjustment circuit 304 controls the quantizer clock (CKQ) phase to adjust the feedforward path phase and/or timing. In some examples, the timing adjustment circuit 304 is digitally tunable.

The timing adjustment circuit 304 controls the phase of the quantizer clock, CKQ, for adjusting the feedforward path delay t_{QD} for covering changes in the frequency f_{CK} as well as tracking PVT. The feedforward path timing t_{QD} control for delay matching relaxes the delay element design, namely the continuous-time filter 212, by taking the burden of the exact matching from the delay element. To adjust the delay t_{QD}, either or both the quantizer's and DAC's clock phases may be controlled. However, controlling the quantizer clock CKQ may be more desirable given that the DAC clock CKD may have much stricter jitter requirements. In contrast, any non-ideality at the quantizer 204 may be treated as quantization noise and, as a consequence, may be canceled at the following stages.

For non-matched CTP, the cancellation error increases toward high frequencies, e.g., band-edge, as the feedforward path sinc roll off is not matched by the magnitude response of the forward path. In some examples, for better amplitude matching, the feedforward path further includes an equalizer 310 coupled to an input 312 of the quantizer 204 and configured to receive a control signal CTRL_{EQ}. The equalizer 310 is configured for adjusting an amplitude and/or phase of the analog input signal S_{IN} or matching between the feedforward path and the forward path over the desired bandwidth.

In some examples, the residue generation arrangement 300 includes a current buffer 314 coupled between the summation node 214 and the amplifier 218.

In some examples, the residue generation arrangement 300 includes a low-dropout regulator LDO 316 coupled with the digital-to-analog converter 206. The LDO 316 may receive a control signal CTRL_{LDO} and be used to adjust a reference voltage of the digital-to-analog converter 206 for matching between the feedforward path and the forward path.

In some examples, the reference voltage of the quantizer is tuned to adjust the forward path and the feedforward path amplitude matching.

The timing adjustment circuit 304 (TGEN), which controls the CKQ clock phase or clock delay of the feedforward path, may be implemented in various ways including a digitally tunable inverter delay line, a delay lock loop, a tunable delay filter, a tunable delay circuit, and/or a phase interpolator. An example of phase interpolation implementation is described with respect to FIG. 4.

FIG. 4 is a block diagram of an example of a timing adjustment circuit 400 that may implement various techniques of this disclosure. The timing adjustment circuit 400 is an example of the timing adjustment circuit 304 of FIG. 3.

The timing adjustment circuit 400 includes a multi-phase clock generation circuit 402 configured to receive the differential clock signal CK, such as a 4 Gigahertz (GHz) to 8 GHz clock signal. The multi-phase clock generation circuit 402 may generate quadrature waveforms or 8 reference phases from the differential clock input. In some examples, the multi-phase generation circuit 402 is implemented as a polyphase filter.

A phase interpolator 404 (PI) is coupled to receive an output signal, e.g., 4-bit, from an output 406 of the multi-phase clock generation circuit 402. The phase interpolator 404 may use the quadrature input clock and 5-bit code (PI code<4:0>, which includes least significant bits (LSBs)) to generate a variable delay quadrature output clock. This specific non-limiting example has a 0 - π/2 phase control range with 5-bit accuracy.

The timing adjustment circuit 400 further includes a phase selector 410 (PS) coupled with and configured to receive an output signal, e.g., 4 differential quadrature clocks whose phases are controlled by 404 with PI code<4:0>, from an output 408 of the phase interpolator 404. The phase selector 410 selects, using PS Code<1:0>, which includes most significant bits (MSBs)), the desired clock to feed to the quantizer 204. Together, the PI code and the PS code form the CTRL_{TGEN}<6:0> input to the TGEN timing adjustment circuit 400 of FIG. 3. Thus, in the example shown, the timing adjustment circuit 400 may achieve a full-scale, i.e., 0 - 2π, phase control range with 7-bit accuracy.

To summarize, the timing adjustment circuit 400 of FIG. 4 receives quadrature input signals representing different phase relationships (0, 90, 180, and 270 degrees) and generates corresponding output signals with controllable delays. The phase interpolator 404 performs fine delay adjustments within 90-degree quadrants using multi-bit control codes, and the phase selector 410 determines quadrant selection for coarse phase control.

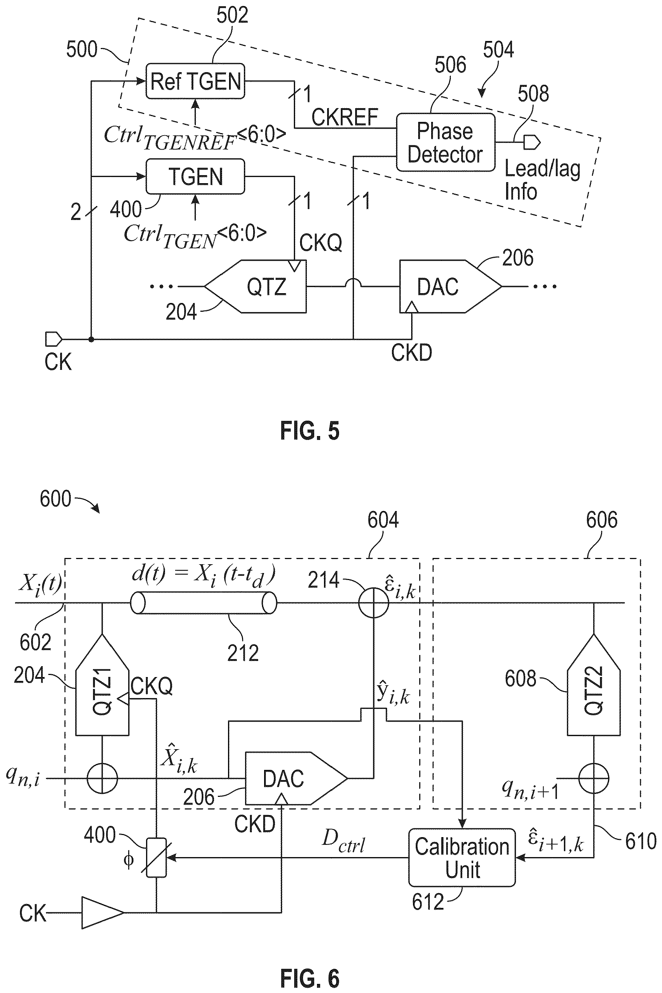

FIG. 5 is a block diagram of an example of a calibration unit 500 for controlling a relationship between the delayed or advanced clock signal and the clock signal in accordance with this disclosure. The timing adjustment circuit 400 aims to control the CKQ clock edge with respect to the CKD clock edge with high accuracy, such as picosecond. The desired delay between CKQ and CKD clocks may be sustained over PVT in different ways.

The calibration unit 500 controls a relationship between the delayed clock signal CKQ generated by the timing adjustment circuit 400 and the clock signal CK. In the example shown, the calibration unit 500 includes a replica timing adjustment circuit 502 that is configured to receive the clock signal CK and a reference control signal CTRL_{TGENREF}<6:0> and, in response, generate a reference clock signal CKREF.

The calibration unit 500 of FIG. 5 includes a reference timing adjustment circuit 504 having a phase detector 506, e.g., a phase comparator or phase measurement circuit. In some examples, the phase detector 506 is implemented using a phase frequency detector followed by a charge pump, or a DFF-based approach.

The phase detector 506 compares the clock signal CKD and clock signal CKREF, which is a representation of the delayed clock signal CKQ generated by the timing adjustment circuit 400 applied to the clock input of the quantizer 204. Then, based on the comparison, the phase detector 506 generates a phase detector output signal 508 representing an update to the adjustment signal CTRL_{TGENREF}<6:0> applied to the replica timing generator circuit 502. The phase detector output signal 508 may represent an update to the adjustment signal CTRL_{TGEN}<6:0> applied to the timing adjustment circuit 400, where CTRL_{TGEN}<6:0> includes PI code<4:0> and PS code<1:0>. The phase detector output signal 508 may be used to update the phase interpolator 404 PI code<4:0> and the phase selector 410 PS code<1:0> of FIG. 4. It should be noted that to generate a desired delay, the CTRL_{TGEN}<6:0> adjustment signal may be generated using a lookup table, circuit, or equation. For example, during foreground calibration in the factory, stored CTRL_{TGEN}<6:0> and/or CTRL_{TGENREF}<6:0> codes may be retrieved from a memory device (or determined from an equation). Later, during a background calibration, while the ADC is in operation, the CTRL_{TGEN}<6:0> and/or CTRL_{TGENREF}<6:0> codes may be updated using the calibration techniques described here or below.

When process, voltage, and/or temperature changes, then the clock signal CKREF leads or lags clock signal CKD, which is determined by the phase detector 506. Then, in response, the adjustment signal CTRL_{TGENREF}<6:0> and/or CTRL_{TGEN}<6:0> are updated. In this manner, the replica circuit continuously monitors timing relationships and generates corrections to the adjustment signal to timing adjustment circuit 400. These corrections enable automatic adjustment of delay values to maintain precise timing control despite environmental and operational variations. The calibration may be performed in either the foreground or the background, with the system configured to minimize timing errors through continuous or periodic adjustment of delay control values.

In other examples, the desired delay between CKQ and CKD clocks may be sustained in other ways, such as randomly sampling CKQ and CKD to determine their exact phase difference. As another example, the residue is monitored, such as at the ADC virtual ground, e.g., the summing node. As another example, the back-end ADC may be used to monitor the leakage amplitude (background and/or foreground).

FIG. 6 is a block diagram of another example of a residue generation arrangement 600 with discrete-time signal representation and the quantization noise incurred at the output of the quantizers. The residue generation arrangement 600 includes a calibration unit for controlling a relationship between the delayed clock signal and the clock signal in accordance with this disclosure. For brevity of discussion of the calibration, the current buffer 314 and interstage gain/filter 218 in FIG. 3 are not shown in FIG. 6.

The residue generation arrangement 600 receives an analog input signal xᵢ(t) at an ith stage of the analog input terminal 602 of the analog-to-digital converter, such as the analog-to-digital converter 100 of FIG. 1. Like before, the residue generation arrangement 600 includes a feedforward path with a first quantizer 204 ("QTZ1") and first digital-to-analog converter 206 and a forward path with a continuous-time filter 212. The outputs *x̂_{i,k}* and *ŷ_{i,k}* are the outputs of the quantizer 204 and the digital-to-analog converter 206 at the kₜₕ sample, respectively, and *q_{n,i}* is the quantization error of the quantizer 204. A residue signal *ε̂_{i,k}* is generated by applying the delayed analog input signal xᵢ(t) and the output ŷ*_{i,k}* of the digital-to-analog converter 206 to the summation node 214. The feedforward path components form part of a first continuous-time stage 604, such as the residue-generating stage 102a of FIG. 1.

The residue generation arrangement 600 further includes a second continuous-time stage 606. The second continuous-time stage 606 includes a second quantizer 608 ("QTZ2") coupled with the summation node 214 and configured for digitizing the residue signal ε_{i,k} to generate a digitized residue signal 610. The quantization error of the second quantizer is represented by *q*_{*n,i+*1}

The residue generation arrangement 600 includes a calibration unit 612. The calibration unit 612 is configured for receiving the output of the first quantizer 204, namely the digital signal *x̂_{i,k},* and the digitized residue signal 610 of the second quantizer 608. In response, the calibration unit 612 generates an update to the adjustment signal, shown here as D_{CTRL} (and as CTRL_{TGEN} above), that is applied to the timing adjustment circuit 400 to adjust the clock phase of the feedforward path.

In some examples, the calibration unit 612 generates the update to the adjustment signal by determining a minimum square error (MSE) of the digitized residue signal 610. In an example, the MSE Ψ is determined using Equation 1: $Ψ ≡ \frac{\partial E \left\{{{\hat{ϵ}}_{i}}^{2}\right\}}{\partial ϕ}$

The calibration unit 612 aims to drive the clock phase ϕ to a minimum square error (MSE) of the residue *ε̂ᵢ*.

Calculating the instantaneous MSE Ψ at ADC sampling frequencies with multipliers, however, may be computationally intensive. The present inventors have recognized that the computation of Equation 1 may be relaxed using the principle of signed least means square (LMS), as in Equation 2 below. In some such examples, the calibration unit 612 generates the update to the adjustment signal by determining a signed LMS of the digital signal of the first quantizer. In an example, the LMS E is determined using Equation 2: $Ψ ≅ E \left\{2{\hat{ϵ}}_{i}\frac{\partial {\hat{ϵ}}_{i}}{\partial ϕ}\right\} ⇒ E \left\{{\hat{ϵ}}_{i}\times sgn\left(\frac{\partial {\hat{ϵ}}_{i}}{\partial ϕ}\right)\right\}$

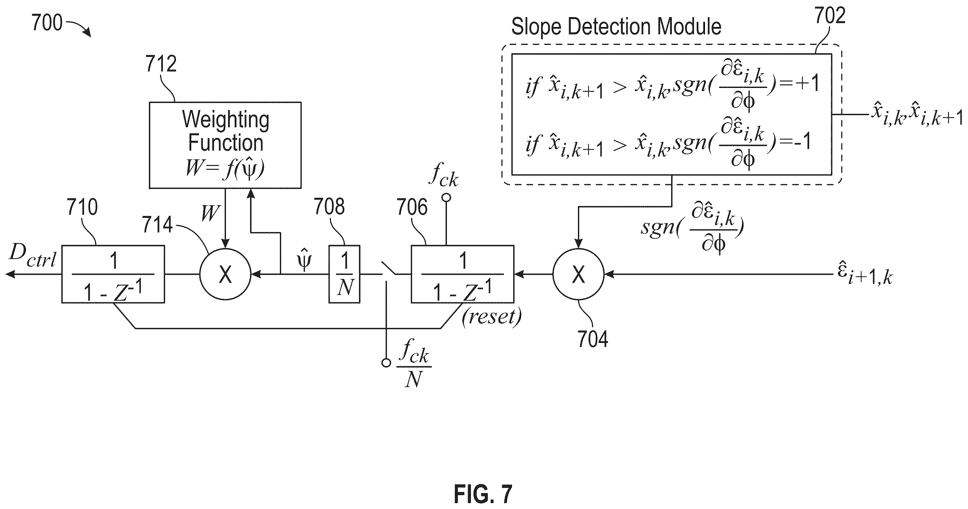

An example of an LMS implementation is shown in FIG. 7. Note the empirical residue value *ε̂ᵢ*, in eq. 1 and 2 is not directly available. Instead, the output of the immediately subsequent quantizer, *ε̂*_{*i*+1}, in Fig. 6 is used as a quantized approximation of *ε̂ᵢ.*

FIG. 7 is an example of an implementation of a signed least means square (LMS) by the calibration unit of FIG. 6. The calibration unit 700 in FIG. 7 is an example of the calibration unit 612 of FIG. 6.

The value of the residue signal *ε̂ᵢ* may be positive or negative depending on the slope of the input waveform *x̂_{i,k}*. The sign of the residue derivative may be defined such that the product of ${\hat{ϵ}}_{i} \times sgn \left(\frac{\partial {\hat{ϵ}}_{i}}{\partial ϕ}\right)$ yields the same polarity for the same phase *ϕ*, regardless of the input slope. For example:
If slope is rising ${\hat{x}}_{i , k + 1} > {\hat{x}}_{i , k} , sgn \left(\frac{\partial {\hat{ϵ}}_{i}}{\partial ϕ}\right) = + 1 ;$ and
If slope is falling ${\hat{x}}_{i , k + 1} < {\hat{x}}_{i , k} , sgn \left(\frac{\partial {\hat{ϵ}}_{i}}{\partial ϕ}\right) = - 1 .$

The calibration unit 700 includes a slope detection module 702 to determine the sign of the derivative of the analog input signal, such as the analog input signal *x̂_{i,k}* in FIG. 6. The output *x̂_{i,k}* of the first quantizer 204 in FIG. 6 is applied to an input of the slope detection module 702, and the slope detection module 702 outputs a sign of the derivative of *ε̂_{i,k}* . The sign of the derivative of *ε̂_{i,k}* is applied to a multiplier 704 along with the digitized residue signal 610 from the second quantizer 608 of FIG. 6, namely the residue *ε̂*_{*i*+1,*k*}.

The product of the multiplier 704, which is essentially a 1xN bit adder, is applied to a first integrator 706, e.g., an accumulator. An averager 708 generates an average value of accumulated N samples of the first integrator 706, which is the signed LMS Ψ̂ and which is then applied to a second integrator 710. The value of the first integrator 706 is then reset periodically at rate lower than the clock rate by an integer factor N. The output of the second integrator 710 is the adjustment signal, shown here as D_{CTRL}, which controls the first quantizer 204 clock tuner to adjust the clock phase ϕ.

In some examples, a weighting function 712 is applied to the output of the averager 708, such as to adjust the clock phase ϕ step size if needed. For example, if a large residue is detected, the weighting function 712 may be adjusted to assist with convergence speed. In FIG. 7, the weighting function 712 and the output of the averager 708 are applied to a multiplier 714, which is then applied to the second integrator 710.

Using these LMS techniques, the calibration unit 700 adapts the CTP clock phase control system to achieve minimum stage residue RMS value at sub-ADCs by computing the signed residue value directly. In addition, the sign of the residue value is determined by detecting the slope of oversampled input waveform, where the oversampled data already exists in the backend ADC in the CTP. Two samples are required for slope detection, and more samples may be desirable for ADCs with a higher oversampling ratio (OSR).

In some examples, the phase control circuit may include more than one delay adjustment circuit sharing a common LMS engine such as the input delay line 212 itself. The phase control circuit may also be adjusted in the presence of non-timing impairments, such as residual DAC output amplitude mismatch, by adapting the LMS Ψ̂ to a new local minimum and relaxing the CTP system tradeoff.

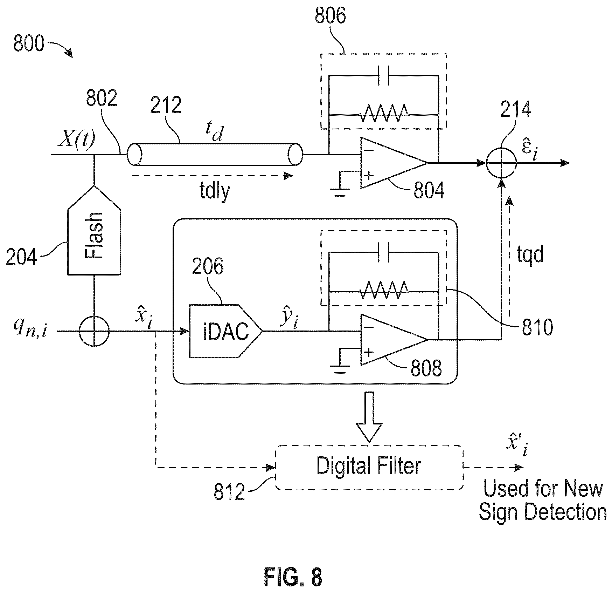

FIG. 8 is a conceptual model of an equivalent-circuit example of a portion of a residue generation arrangement 800 in accordance with this disclosure. The residue generation arrangement 800 moves and replicates the interstage gain/filter 218 in FIG. 3 before the summation node 214. The residue generation arrangement 800 swaps the interstage gain/filter 218 and the summation node 214 with the amplifier 804 and analog filter 806 for the forward path. To maintain circuit equivalence in the feedforward path, the same replica of 218 is added at DAC output accordingly and denoted 808 and 810 respectively. The residue generation arrangement 800 receives an analog input signal x(t) at an analog input terminal 802 of the analog-to-digital converter, such as the analog-to-digital converter 100 of FIG. 1. Like before, the residue generation arrangement 800 includes a feedforward path with a first quantizer 204 ("FLASH") and first digital-to-analog converter 206 and a forward path with a continuous-time filter 212.

The forward path includes an amplifier 804 and an analog filter 806, such as including a capacitor and a resistor connected in parallel. The amplifier 804 and the analog filter 806 are coupled together at an input of the summation node 214.

The residue generation stage 800 is conceptually identical to the residue generation arrangement 600 of FIG. 6 with interstage gain/filter 218 (typical for CTP ADC) included in the feedforward digital-to-analog converter 206. It highlights the presence of the interstage gain/filter, typical for CTP ADC, in both forward and feedforward paths. This is inherent and implicitly reflected in the residue value, *ε̂ᵢ*, in eq 2, already. The slope detection 702, however, does not take the gain/filtering 808+810 into account and works off of the unfiltered signal *x̂ᵢ*. The lack of accounting for the filtering for the slope detection results in a discrepancy from the empirical eq 2. The LMS effectiveness is limited if there is significant frequency content beyond the filter bandwidth in the stage input x(t).

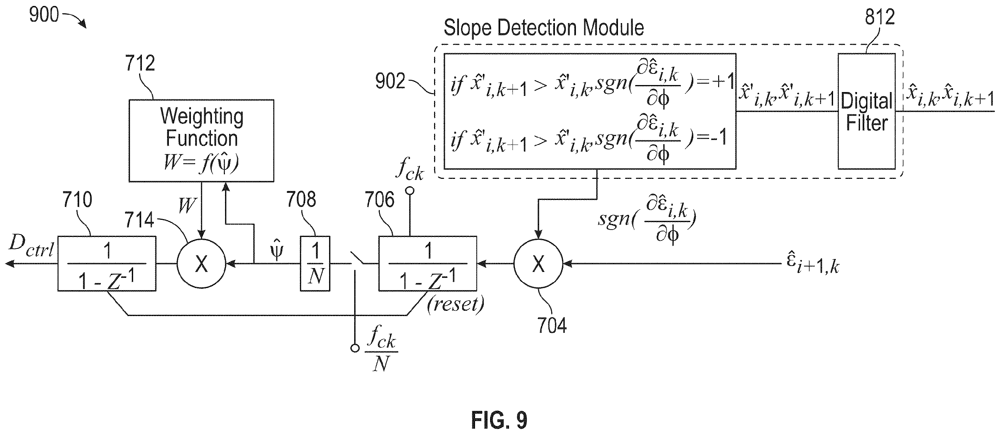

To resolve the signal discrepancy for slope detection, a digital filter 812, e.g., a digital low pass filter, is included in the feedforward path such that the output xᵢ of the quantizer 204 is applied to the digital filter 812, where the frequency response of the digital filter 812 is substantially equivalent to that of the amplifier 808 and the analog filter 810 of the feedforward path. The digital filter 812 generates an output signal x'ᵢ as a new representation of the input for slope detection. An example of an implementation is shown in FIG. 9.

FIG. 9 is another example of an implementation of a least means square (LMS) by the calibration unit of FIG. 6. FIG. 9 includes many components similar to those shown in FIG. 7 and, for brevity, will not be described in detail again.

Using the techniques described above in FIG. 8, the calibration unit 900 includes slope detection module 902 that further includes a digital filter 812, e.g., an Infinite Impulse Response (IIR) filter or Finite Impulse Response (FIR) filter. As discussed above, the digital filter 812 receives the output xᵢ of the quantizer 204, where the frequency response of the digital filter 812 is substantially equivalent to that of the amplifier 808 and the analog filter 810 of the forward path so as to improve the accuracy of the LMS slope detection in eq. 2. The digital filter 812 generates a filtered signal x'ᵢ that may be used for sign detection by the slope detection module 902.

In this manner, the calibration unit 900 of FIG. 9 expands the LMS bandwidth tracking by equalizing the frequency response of underlying signal used for the slope detection ∂*ε̂ᵢ*/∂*ϕ* with that of *ε̂ᵢ* in eq. 2 with straightforward digital techniques.

It should be noted that in some examples, the calibration techniques described in this disclosure may be used for foreground calibration and/or background calibration. In addition, in some examples, the calibration techniques described with respect to FIG. 5 may be combined with the calibration techniques described with respect to FIGS. 6-9.

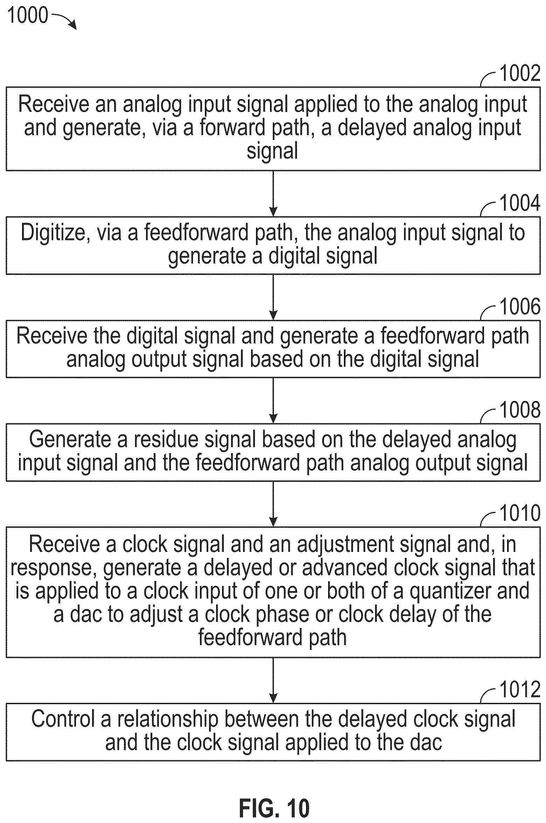

FIG. 10 is a flow diagram of an example of a method 1000 of using a continuous-time analog-to-digital converter (ADC) using various techniques of this disclosure. At block 1002, the method 1000 includes receiving an analog input signal applied to the analog input and generating a delayed analog input signal. For example, the residue generation arrangement 300 of FIG. 3 includes a first continuous-time stage having a forward path including a continuous-time filter 212, where the forward path is coupled with an analog input terminal 302 and configured for receiving an analog input signal Sin applied to the analog input terminal 302 and generating a delayed analog input signal Sdly.

At block 1004, the method 1000 includes digitizing the analog input signal to generate a digital signal. For example, the residue generation arrangement 300 of FIG. 3 includes a feedforward path coupled in parallel with the forward path, where the feedforward path includes a first quantizer 204 for digitizing the analog input signal Sin to generate an output 208.

At block 1006, the method 1000 includes receiving the digital signal and generating a feedforward path analog output signal based on the digital signal. For example, the feedforward path includes digital-to-analog converter 206 coupled with an output of the first quantizer 204 and that is configured for receiving the digital signal from the first quantizer and generating a feedforward path analog output signal based on the digital signal generated by the first quantizer.

At block 1008, the method 1000 includes generating a residue signal based on the delayed analog input signal and the feedforward path analog output signal. For example, the residue generation arrangement 300 of FIG. 3 includes a summation node 214 configured for generating a residue signal Sres based on the delayed analog input signal Sdly and the feedforward path analog output signal Sdac.

At block 1010, the method 1000 includes receiving a clock signal and an adjustment signal and, in response, generating a delayed or advanced clock signal that is applied to a clock input of one or both of the first quantizer and the DAC to adjust a clock phase or clock delay of the feedforward path. For example, the residue generation arrangement 300 of FIG. 3 includes a timing adjustment circuit 304 (TGEN) configured for receiving a clock signal (such as clock signal CK in FIG. 4) and an adjustment signal CTRL_{TGEN} and, in response, generating a delayed or advanced clock signal that is applied to a clock input of one or both of the first quantizer and the DAC to adjust a clock phase or clock delay of the feedforward path. For example, delayed clock signal CKQ is applied to the quantizer 204 in FIG. 3 and the delayed clock signal CKD is applied to the digital-to-analog converter 206 in FIG. 3.

At block 1012, the method 1000 optionally includes controlling a relationship between the delayed clock signal and the clock signal applied to an input of the digital-to-analog converter (DAC). For example, the residue generation arrangement 300 of FIG. 3 may include a calibration unit 500, such as shown in FIG. 5, and/or a calibration unit 612, such as shown in FIG. 6, where the calibration unit 612 may implement the calibration techniques shown in FIGS. 7-9.

### Various Notes

Each of the non-limiting claims or examples described herein may stand on its own, or may be combined in various permutations or combinations with one or more of the other examples.

The above detailed description includes references to the accompanying drawings, which form a part of the detailed description. The drawings show, by way of illustration, specific embodiments in which the invention may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more claims thereof), either with respect to a particular example (or one or more claims thereof), or with respect to other examples (or one or more claims thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Method examples described herein may be machine or computer-implemented at least in part. Some examples may include a computer-readable medium or machine-readable medium encoded with instructions operable to configure an electronic device to perform methods as described in the above examples. An implementation of such methods may include code, such as microcode, assembly language code, a higher-level language code, or the like. Such code may include computer readable instructions for performing various methods. The code may form portions of computer program products. Further, in an example, the code may be tangibly stored on one or more volatile, non-transitory, or non-volatile tangible computer-readable media, such as during execution or at other times. Examples of these tangible computer-readable media may include, but are not limited to, hard disks, removable magnetic disks, removable optical disks (e.g., compact discs and digital video discs), magnetic cassettes, memory cards or sticks, random access memories (RAMs), read only memories (ROMs), and the like.

There follows a list of numbered features defining particular embodiments of the present disclosure. Where a numbered feature refers to one or more earlier numbered features then those features should be considered together in combination.
1. A residue generation arrangement for use in a continuous-time stage of an analog-to-digital converter (ADC), the residue generation arrangement comprising:
   a forward path including a continuous-time filter, the forward path coupled with an analog input and configured for receiving an analog input signal applied to the analog input and generating a delayed analog input signal;
   a feedforward path coupled in parallel with the forward path, the feedforward path including:
      a quantizer for digitizing the analog input signal to generate a digital signal; and
      a digital-to-analog converter (DAC) coupled with an output of the quantizer and configured for receiving the digital signal from the quantizer and generating a feedforward path analog output signal based on the digital signal generated by the quantizer;
   a summation node configured for generating a residue signal based on the delayed analog input signal and the feedforward path analog output signal; and
   a timing adjustment circuit configured for receiving a clock signal and an adjustment signal and, in response, generating a delayed or advanced clock signal that is applied to a clock input of one or both of the quantizer and the DAC to adjust a clock phase or clock delay of the feedforward path.
2. The residue generation arrangement of feature 1, wherein the timing adjustment circuit includes one or more of a phase interpolator, a delay lock loop, a tunable delay line, and a tunable delay circuit.
3. The residue generation arrangement of feature 2, wherein the timing adjustment circuit includes a phase selector coupled with an output of the phase interpolator.
4. The residue generation arrangement of any of features 1 to 3, wherein the feedforward path further includes:
   an equalizer coupled to an input of the quantizer and configured for adjusting an amplitude and/or phase of the analog input signal.
5. The residue generation arrangement of any of features 1 to 4, comprising:
   a calibration unit configured for controlling a relationship between the delayed clock signal and the clock signal.
6. The residue generation arrangement of feature 5, wherein the calibration unit includes:
   a reference timing adjustment circuit including a phase detector, the phase detector configured for:
   comparing the clock signal and a representation of the delayed clock signal generated by the timing adjustment circuit applied to the clock input of the quantizer; and
   generating, based on the comparison, a phase detector output signal representing an update to the adjustment signal applied to the timing adjustment circuit.
7. The residue generation arrangement of feature 5, wherein the quantizer is a first quantizer, wherein the continuous-time stage is a first continuous-time stage, wherein the ADC includes a second continuous-time stage having a second quantizer coupled with the summation node and configured for digitizing the residue signal to generate a digitized residue signal, and wherein the calibration unit is configured for:
   receiving the digital signal of the first quantizer;
   receiving the digitized residue signal of the second quantizer; and
   generating an update to the adjustment signal applied to the timing adjustment circuit to adjust the clock phase of the feedforward path.
8. The residue generation arrangement of feature 7, wherein generating the update to the adjustment signal applied to the timing adjustment circuit to adjust the clock phase of the feedforward path includes:
   determining a minimum square error (MSE) of the digitized residue signal.
9. The residue generation arrangement of feature 8, wherein generating the update to the adjustment signal applied to the timing adjustment circuit to adjust the clock phase of the feedforward path includes:
   determining a signed least means square (LMS) of the digital signal of the first quantizer.
10. The residue generation arrangement of any of features 1 to 9, wherein the continuous-time filter has a fixed delay.
11. A residue generation arrangement for use in a continuous-time analog-to-digital converter (ADC), the residue generation arrangement comprising:
   a first continuous-time stage including:
   a forward path including a continuous-time filter, the forward path coupled with an analog input and configured for receiving an analog input signal applied to the analog input and generating a delayed analog input signal;
   a feedforward path coupled in parallel with the forward path, the feedforward path including:
      a first quantizer for digitizing the analog input signal to generate a digital signal; and
      a digital-to-analog converter (DAC) coupled with an output of the first quantizer and configured for receiving the digital signal from the first quantizer and generating a feedforward path analog output signal based on the digital signal generated by the first quantizer;
      a summation node configured for generating a residue signal based on the delayed analog input signal and the feedforward path analog output signal;
      a timing adjustment circuit configured for receiving a clock signal and an adjustment signal and, in response, generating a delayed or advanced clock signal that is applied to a clock input of one or both of the first quantizer and the DAC to adjust a clock phase or clock delay of the feedforward path; and
      a calibration unit configured for controlling a relationship between the delayed clock signal and the clock signal applied to an input of the digital-to-analog converter (DAC).
12. The residue generation arrangement of feature 11, wherein the calibration unit includes:
   a reference timing adjustment circuit including a phase detector, the phase detector configured for:
   comparing the clock signal and a representation of the delayed clock signal generated by the timing adjustment circuit applied to the clock input of the first quantizer; and
   generating, based on the comparison, a phase detector output signal representing an update to the adjustment signal applied to the timing adjustment circuit.
13. The residue generation arrangement of feature 11 or 12, wherein the ADC includes a second continuous-time stage having a second quantizer coupled with the summation node and configured for digitizing the residue signal to generate a digitized residue signal, and wherein the calibration unit is configured for:
   receiving the digital signal of the first quantizer;
   receiving the digitized residue signal of the second quantizer; and
   generating an update to the adjustment signal applied to the timing adjustment circuit to adjust the clock phase of the feedforward path.
14. The residue generation arrangement of feature 13, wherein generating the update to the adjustment signal applied to the timing adjustment circuit to adjust the clock phase of the feedforward path includes:
   determining a minimum square error (MSE) of the digitized residue signal.
15. The residue generation arrangement of feature 13 or 14, wherein generating the update to the adjustment signal applied to the timing adjustment circuit to adjust the clock phase of the feedforward path includes:
   determining a signed least means square (LMS) of the digital signal of the first quantizer.
16. The residue generation arrangement of feature 15, wherein determining the signed least means square (LMS) of the digital signal of the first quantizer includes:
   filtering an output of the first quantizer to generate a filtered signal; and
   detecting, using the filtered signal, a slope of the filtered signal.
17. The residue generation arrangement of any of features 11 to 16, wherein the calibration unit includes:
   a reference timing adjustment circuit including a phase detector, the phase detector configured for:
   comparing the clock signal and a representation of the delayed clock signal generated by the timing adjustment circuit applied to the clock input of the quantizer; and
   generating, based on the comparison, a phase detector output signal representing an update to the adjustment signal applied to the timing adjustment circuit.
18. A method of using an analog-to-digital converter (ADC), the method comprising:
   receiving an analog input signal applied to an analog input and generating a delayed analog input signal;
   digitizing, via a feedforward path, the analog input signal to generate a digital signal;
   receiving the digital signal and generating a feedforward path analog output signal based on the digital signal;
   generating a residue signal based on the delayed analog input signal and the feedforward path analog output signal; and
   receiving a clock signal and an adjustment signal and, in response, generating a delayed or advanced clock signal that is applied to a clock input of one or both of a quantizer and a digital-to-analog converter to adjust a clock phase or clock delay of the feedforward path.
19. The method of feature 18, further comprising:
   controlling a relationship between the delayed clock signal and the clock signal applied to an input of the digital-to-analog converter.
20. The method of feature 19, wherein controlling the relationship between the delayed clock signal and the clock signal applied to the input of the digital-to-analog converter includes:
   comparing the clock signal and a representation of the delayed clock signal; and
   generating, based on the comparison, a phase detector output signal representing an update to the adjustment signal applied to a timing adjustment circuit.

## Claims

1. A residue generation arrangement for use in a continuous-time stage of an analog-to-digital converter (ADC), the residue generation arrangement comprising:
a forward path including a continuous-time filter, the forward path coupled with an analog input and configured for receiving an analog input signal applied to the analog input and generating a delayed analog input signal;
a feedforward path coupled in parallel with the forward path, the feedforward path including:
a quantizer for digitizing the analog input signal to generate a digital signal; and
a digital-to-analog converter (DAC) coupled with an output of the quantizer and configured for receiving the digital signal from the quantizer and generating a feedforward path analog output signal based on the digital signal generated by the quantizer;
a summation node configured for generating a residue signal based on the delayed analog input signal and the feedforward path analog output signal; and
a timing adjustment circuit configured for receiving a clock signal and an adjustment signal and, in response, generating a delayed or advanced clock signal that is applied to a clock input of one or both of the quantizer and the DAC to adjust a clock phase or clock delay of the feedforward path.

2. The residue generation arrangement of claim 1, wherein the timing adjustment circuit includes one or more of a phase interpolator, a delay lock loop, a tunable delay line, and a tunable delay circuit; and optionally futher includes a phase selector coupled with an output of the phase interpolator.

3. The residue generation arrangement of claims 1 or 2, wherein the feedforward path further includes:
an equalizer coupled to an input of the quantizer and configured for adjusting an amplitude and/or phase of the analog input signal.

4. The residue generation arrangement of any of claims 1 to 3, comprising:
a calibration unit configured for controlling a relationship between the delayed clock signal and the clock signal.

5. The residue generation arrangement of claim 4, wherein the quantizer is a first quantizer, wherein the continuous-time stage is a first continuous-time stage, wherein the ADC includes a second continuous-time stage having a second quantizer coupled with the summation node and configured for digitizing the residue signal to generate a digitized residue signal, and wherein the calibration unit is configured for:
receiving the digital signal of the first quantizer;
receiving the digitized residue signal of the second quantizer; and
generating an update to the adjustment signal applied to the timing adjustment circuit to adjust the clock phase of the feedforward path.

6. The residue generation arrangement of any of claims 1 to 5, wherein the continuous-time filter has a fixed delay.

7. A residue generation arrangement for use in a continuous-time analog-to-digital converter (ADC), the residue generation arrangement comprising:
a first continuous-time stage including:
a forward path including a continuous-time filter, the forward path coupled with an analog input and configured for receiving an analog input signal applied to the analog input and generating a delayed analog input signal;
a feedforward path coupled in parallel with the forward path, the feedforward path including:
a first quantizer for digitizing the analog input signal to generate a digital signal; and
a digital-to-analog converter (DAC) coupled with an output of the first quantizer and configured for receiving the digital signal from the first quantizer and generating a feedforward path analog output signal based on the digital signal generated by the first quantizer;
a summation node configured for generating a residue signal based on the delayed analog input signal and the feedforward path analog output signal;
a timing adjustment circuit configured for receiving a clock signal and an adjustment signal and, in response, generating a delayed or advanced clock signal that is applied to a clock input of one or both of the first quantizer and the DAC to adjust a clock phase or clock delay of the feedforward path; and
a calibration unit configured for controlling a relationship between the delayed clock signal and the clock signal applied to an input of the digital-to-analog converter (DAC).

8. The residue generation arrangement of claims 4 or 7, wherein the calibration unit includes:
a reference timing adjustment circuit including a phase detector, the phase detector configured for:
comparing the clock signal and a representation of the delayed clock signal generated by the timing adjustment circuit applied to the clock input of the first quantizer; and
generating, based on the comparison, a phase detector output signal representing an update to the adjustment signal applied to the timing adjustment circuit.

9. The residue generation arrangement of claim 8 when dependent on claim 7, wherein the ADC includes a second continuous-time stage having a second quantizer coupled with the summation node and configured for digitizing the residue signal to generate a digitized residue signal, and wherein the calibration unit is configured for:
receiving the digital signal of the first quantizer;
receiving the digitized residue signal of the second quantizer; and
generating an update to the adjustment signal applied to the timing adjustment circuit to adjust the clock phase of the feedforward path.

10. The residue generation arrangement of claims 5 or 9, wherein generating the update to the adjustment signal applied to the timing adjustment circuit to adjust the clock phase of the feedforward path includes one or more of:
a) determining a minimum square error (MSE) of the digitized residue signal; and/or
b)
determining a signed least means square (LMS) of the digital signal of the first quantizer.

11. The residue generation arrangement of claim 10, wherein determining the signed least means square (LMS) of the digital signal of the first quantizer includes:
filtering an output of the first quantizer to generate a filtered signal; and
detecting, using the filtered signal, a slope of the filtered signal.

12. The residue generation arrangement of any of claims 7 to 11, wherein the calibration unit includes:
a reference timing adjustment circuit including a phase detector, the phase detector configured for:
comparing the clock signal and a representation of the delayed clock signal generated by the timing adjustment circuit applied to the clock input of the quantizer; and
generating, based on the comparison, a phase detector output signal representing an update to the adjustment signal applied to the timing adjustment circuit.

13. A method of using an analog-to-digital converter (ADC), the method comprising:
receiving an analog input signal applied to an analog input and generating a delayed analog input signal;
digitizing, via a feedforward path, the analog input signal to generate a digital signal;
receiving the digital signal and generating a feedforward path analog output signal based on the digital signal;
generating a residue signal based on the delayed analog input signal and the feedforward path analog output signal; and
receiving a clock signal and an adjustment signal and, in response, generating a delayed or advanced clock signal that is applied to a clock input of one or both of a quantizer and a digital-to-analog converter to adjust a clock phase or clock delay of the feedforward path.

14. The method of claim 13, further comprising:
controlling a relationship between the delayed clock signal and the clock signal applied to an input of the digital-to-analog converter.

15. The method of claim 14, wherein controlling the relationship between the delayed clock signal and the clock signal applied to the input of the digital-to-analog converter includes:
comparing the clock signal and a representation of the delayed clock signal; and
generating, based on the comparison, a phase detector output signal representing an update to the adjustment signal applied to a timing adjustment circuit.
